Europäisches Patentamt

European Patent Office

Office européen des brevets

(19)

(11) Numéro de publication: **0 343 722**

**A1**

(12)

# DEMANDE DE BREVET EUROPEEN

(21) Numéro de dépôt: **89201261.8**

(22) Date de dépôt: **18.05.89**

(51) Int. Cl.⁴: **H01L 39/12 , H01L 39/14 , H01L 27/18**

(30) Priorité: **24.05.88 FR 8806856**

(43) Date de publication de la demande:
**29.11.89 Bulletin 89/48**

(84) Etats contractants désignés:
**CH DE FR GB IT LI NL SE**

(71) Demandeur: **LABORATOIRES D'ELECTRONIQUE ET DE PHYSIQUE APPLIQUEE L.E.P.**
**3, Avenue Descartes**
**F-94450 Limeil-Brévannes(FR)**

(84) **FR**

Demandeur: **N.V. Philips' Gloeilampenfabrieken**
**Groenewoudseweg 1**
**NL-5621 BA Eindhoven(NL)**

(84) **CH DE GB IT LI NL SE**

(72) Inventeur: **Baundry, Hughes Société civile S.P.I.D.**
**209, rue de l'Université**
**F-75007 Paris(FR)**

Inventeur: **Monneraye, Marc Société civile S.P.I.D.**
**209, rue de l'Université**
**F-75007 Paris(FR)**

Inventeur: **Morhaim, Claude Société civile S.P.I.D.**
**209, rue de l'Université**
**F-75007 Paris(FR)**

(74) Mandataire: **Landousy, Christian et al Société Civile S.P.I.D. 209, Rue de l'Université**
**F-75007 Paris(FR)**

(54) **Dispositif supraconducteur sérigraphié.**

(57) Dispositif électronique comprenant, réalisé sur un substrat S en céramique, un circuit formé d'au moins une couche sérigraphiée pour réaliser des conducteurs, et une couche sérigraphiée pour réaliser des plots P de contact électrique avec les conducteurs, caractérisé en ce que le substrat S est en magnésie (MgO) frittée polycristalline, en ce que la couche (1) réalisant les conducteurs est en $YBa_2Cu_3O_{7-x}$ supraconducteur, en ce que les plots P de contact sont formés d'une couche (11) sérigraphiée conductrice dont la phase active est constituée d'un métal choisi parmi l'or, l'argent-palladium, l'or-palladium, l'or-platine ou l'argent-platine et en ce que ces plots P sont reliés aux conducteurs supra-conducteurs (1) par une couche (12) d'argent sérigraphiée en second niveau.

Applications : circuits hybrides hyperfréquences supraconducteurs, boîtier pour circuits intégrés.

FIG. 1

## DISPOSITIF SUPRACONDUCTEUR SERIGRAPHIE"

L'invention concerne un dispositif électronique comprenant, réalisé sur un substrat en céramique, un circuit formé d'au moins une couche sérigraphiée pour réaliser des conducteurs et une couche sérigraphiée pour réaliser des plots de contact électrique avec les conducteurs.

L'invention trouve son application dans la réalisation de circuits hybrides dans le domaine des hyperfréquences notamment, ainsi que dans la réalisation de connexions formées sur les boîtiers supports de dispositifs semiconducteurs intégrés, l'ensemble de ces circuits et dispositifs étant réalisés au moyen de matériaux supraconducteurs et destinés à fonctionner à des températures très basses.

La formation de films supraconducteurs de Y-Ba-Cu-O par sérigraphie est connue de la publication "Synthesis of superconducting films of the Y-Ba-Cu-O System by a screen printing method" par R.C. BUDHANI, Sing-MO H.TZENG, et alii dans "Appl. Phys. Lett. 51 (16), 19 october 1987, pp. 1277-1279.

Ce document rapporte que la température de transition de supraconductivité, l'état de surface de la couche, la résistivité, la structure cristalline, et l'adhérence du film au substrat, sont très sensibles au traitement thermique postérieur au dépôt sérigraphié sur la couche.

La composition de départ pour réaliser une encre sérigraphiable est formée de : Ba $CO_3$, Cu 0, $Y_2O_3$, en poudres, qui sont mélangées, broyées puis portées à une température de 950°C pendant 24 heures dans l'air. Le mélange est ensuite refroidi lentement puis broyé en poudre fine.

Le mélange est incorporé dans un support rhéologique organique pour former l'encre sérigraphiable. La couche est sérigraphiée sur un substrat formé :
- de saphir
- ou d'alumine polycristalline

Le film, une fois sérigraphié, est séché à 300°C pendant une heure.

La publication citée montre que, lorsque la température de cuisson est inférieure à 950°C, les films sérigraphiés ne présentent pas d'adhérence au substrat ; et que, lorsque la température de cuisson est supérieure à 1000°C, alors, l'adhérence au substrat est bonne, mais il se produit une recristallisation du matériau sérigraphié, provoquant de larges hétérogénéités de composition, avec notamment la ségrégation de batonnets d'oxyde de Y et de Cu.

Selon le document cité, des couches à la fois homogènes et adhérentes au substrat ont pu être obtenues par une cuisson à 750°C pendant 4 heures suivie d'une cuisson à 1000°C pendant 30 mn. La composition est alors un mélange de $Y_1Ba_2Cu_3O_{6,9}$ et de Ba Cu $O_2$ en faibles proportions.

Des plots en Or (Au) ont été évaporés pour réaliser des contacts afin de mettre en oeuvre des tests. La résistivité zéro est obtenue sur un substrat en saphir pour 79°K, et sur un substrat en alumine ($Al_2O_3$) pour 70°K. L'effet supraconducteur du matériau massif se produit vers 90°K.

La publication citée révèle que de nombreux essais ont été faits, avec les matériaux cités, en fonction des températures de cuisson, et que les couches obtenues sont particulièrement sensibles à ces températures de cuisson, étant soit non adhérentes, soit décomposées dès que l'on s'écarte des conditions prescrites.

La formation de films supraconducteurs de Y-Ba-Cu-O par sérigraphie est également connue de la publication "Some problems in the Preparation of Superconducting oxide Films on Ceramic Substrates" par Hideomi KOINUMA, Masashi KAWASAKI et alii dans "Japanese Journal of Applied Physics, Vol 26, n° 5, May 1987, pp. L763-L765.

Cette publication rapporte la réalisation de couches de La-Sr-Cu-O et Yb-Ba-Cu-O sur différents substrats tels que le quartz, l'alumine ($AL_2O_3$), l'oxyde de zircone stabilisé par l'oxyde d'Y (YSZ) et $SrTiO_3$. Il apparaît à la suite des essais réalisés entre autres par sérigraphie que de mauvais résultats sont obtenus lorsque la température de cuisson atteint 1000°C, et lorsque des substrats tels que le quartz ou l'alumine sont utilisés. Cette publication enseigne que des fentes sont observées dans les couches, et que ces mauvais résultats sont dûs notamment :
. au coefficient de dilatation non approprié de l'alumine et du quartz vis-à-vis des matériaux employés pour réaliser les couches supraconductrices,
. au fait qu'il apparaît des interactions entre la couche supraconductrice et le substrat à hautes températures, c'est-à-dire aux températures supérieures à 800°C, interactions telles que, par exemple, la diffusion d'un composant métallique dans le substrat.

Il est encore connu de la publication "Thin-film synthesis of the high-$T_c$ oxide superconductor $YBa_2Cu_3O_7$ by electron-beam codeposition" par M. NAITO, R.H. HAMMOND et aliidans "J. MATER. RES. 2(6) Nov/Dec. 1987 pp. 713-72" de réaliser des couches supraconductrices en films minces sur différents substrats tels que $Al_2O_3$, $ZrO_2$, MgO et $SrTiO_3$.

Ce document traite tout particulièrement de l'interdiffusion entre le matériau Y-Ba-Cu-O et les

substrats en $Al_2O_3$ et de ses conséquences sur le phénomène de supraconductivité.

Pour palier les effets nocifs de l'interdiffusion du matériau supraconducteur dans $Al_2O_3$, le document cité enseigne l'utilisation de couches tampons notamment de $ZrO_2$ comme donnant les meilleurs résultats.

Le document cité étudie également le dépôt d'un film mince d'Y-Ba-Cu-O sur un substrat massif de MgO. Lorsque les films minces sont riches en Y, ils montrent une faible interdiffusion avec MgO, tandis que lorsque les films minces sont riches en Ba ils montrent une interdiffusion considérable, notamment du Mg du substrat vers la couche et où ce Mg se substitue à un site Ba ou un site Cu. Les performances supraconductrices sont loin, d'autre part des performances attendues.

Enfin ce document n'enseigne pas à réaliser des couches sérigraphiées sur MgO.

Il résulte de l'étude des documents précédents queleur enseignement ne permet pas de tirer des conclusions définitives, et ne fournit pas de recette de succès assuré pour obtenir des couches supraconductrices sérigraphiées, solides, performantes, reproductibles et donc industrialisables.

Ainsi le substrat $Al_2O_3$ semble à coup sur donner de mauvais résultats selon les second et troisième documents, alors que le premier document obtenait de bons résultats avec ce substrat dans certaines conditions.

Le troisième document préconise l'utilisation de substrats en $ZrO_2$, en montrant les difficultés rencontrées dans l'utilisation de substrats en MgO. Ce dernier document n'enseigne pas à faire des couches sérigraphiées, et les deux autres documents enseignent combien est grande l'influence du substrat, et combien sont importantes et délicates à mettre au point les conditions de cuisson de la couche sérigraphiée.

C'est pourquoi la présente invention propose d'abord un dispositif et ensuite un procédé de réalisation de ce dispositif et notamment un procédé de réalisation des couches sérigraphiées qui permet de résoudre les problèmes soulevés à savoir :

- la décomposition de la couche lors de la cuisson ;
- l'apparition de fentes dans la couche sérigraphiée ;
- l'interdiffusion avec le substrat ;
- la mauvaise adhérence avec le substrat ;
- les mauvaises performances supraconductrices (par exemple la non obtention de la résistivité zéro).

Selon l'invention, ces problèmes sont résolus par un dispositif tel que défini dans le préambule et caractérisé en ce que le substrat est en magnésie (MgO) frittée polycristalline, et en ce que la couche réalisant les conducteurs est en $YBa_2Cu_3O_{7-x}$ supraconducteur, où $0 < x < 0,5$.

Le choix du matériau du substrat en coopération avec le choix du matériau supraconducteur sérigraphié permet notamment de résoudre ces problèmes.

En effet, la magnésie présente, aux hautes températures de cuisson de la couche sérigraphiée d'Y-Ba-Cu-O, le coefficient de dilatation le mieux adapté à celui de ce composé par rapport aux autres matériaux pour substrats connus de l'état de la technique. Cette propriété permet d'éviter l'apparition des fentes dans la couche, et la mauvaise adhérence avec le substrat.

Selon l'invention, il est proposé aussi un tel dispositif en outre caractérisé en ce que les plots de contact sont formés d'une couche sérigraphiée conductrice dont la phase active est constituée d'un métal choisi parmi l'or, l'argent-palladium, l'or-palladium, l'or-platine ou l'argent-platine et en ce que ces plots sont reliés aux conducteurs supraconducteurs par une couche d'argent sérigraphiée en second niveau.

De tels plots de contact permettent en effet d'éviter au mieux la diminution des performances supraconductrices dues aux contacts électriques.

D'autre part, la magnésie a aussi été choisie pour former le substrat, en raison de ses propriétés mécaniques favorables qui permettent de la façonner de manière à lui faire présenter une forme appropriée à coopérer avec un fluide de refroidissement, notamment une forme creuse pour contenir ou véhiculer le fluide, ou une forme en queue pour être mis en contact avec le fluide, et en raison de sa meilleure conductibilité thermique par rapport aux autres substrats connus de l'état de la technique permettant d'atteindre facilement et rapidement les températures de fonctionnement voulues.

De plus, un procédé de réalisation est fourni dans lequel les conditions de cuisson de la couche d'Y-Ba-Cu-O sont choisies pour éviter d'atteindre des températures de décomposition de la couche, ou des températures où commence l'interdiffusion avec le substrat. Ainsi on peut atteindre de bonnes performances supraconductrices.

L'invention sera mieux comprise au moyen de la description suivante illustrée par les figures annexées, dont :

- la figure 1 qui représente schématiquement en coupe un circuit supraconducteur conforme à l'invention sur un substrat plan ;

- la figure 2 qui représente schématiquement en coupe un tel circuit réalisé sur un substrat creux ;

- la figure 3 qui représente schématiquement en coupe un tel circuit sur un substrat muni d'une queue ;

- la figure 4 qui représente schématiquement en coupe un tel circuit sur un substrat constituant aussi un support, ou une partie d'un boîtier pour une plaquette de circuit intégré.

- la figure 5 représente l'alongement relatif $\Delta L/L$ de différents matériaux pour substrat en fonction de la température.

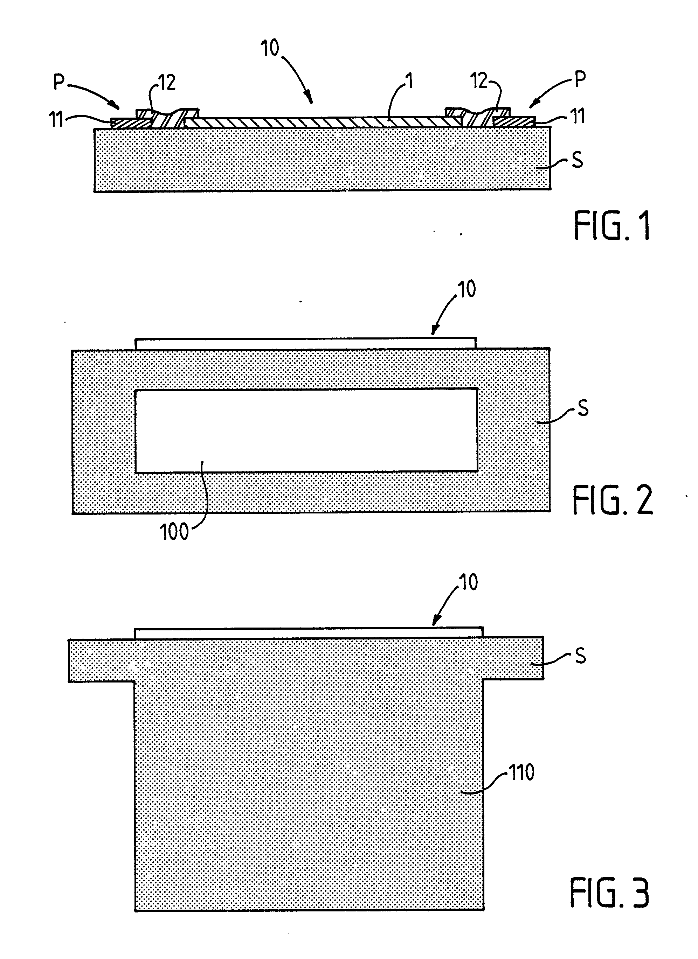

Tel que représenté en coupe sur la figure 1 le circuit 10 selon l'invention comporte au moins une ligne d'interconnexion 1 formée d'une couche sérigraphiée d'un matériau supraconducteur aux extrémités de laquelle sont disposés des plots de contact électrique P. Ce circuit est disposé en surface d'un substrat S. Les plots P de contact électrique sont formés d'une couche conductrice sérigraphiée 11 qui est reliée à la couche supraconductrice 1 par une couche conductrice 12 de second niveau, également sérigraphiées.

Le matériau pour constituer le substrat a été choisi en relation étroite avec le choix du matériau supraconducteur.

En effet, la méthode choisie pour réaliser le circuit, est une méthode de réalisation de couches épaisses par sérigraphie. Cette méthode comporte d'une façon connue de l'état de la technique, au moins une étape de cuisson de la couche sérigraphiée, à température élevée.

Il est donc indispensable de choisir un substrat et des composés sérigraphiables qui présentent le coefficient de dilatation le plus proche dans le domaine délimité par la température d'utilisation et la température de cuisson des couches.

Dans le domaine d'utilisation du dispositif supraconducteur obtenu par sérigraphie, ce domaine va de $T_c \simeq 80°$ K, température qui correspond à l'utilisation, à environ $1200°$ K, température qui correspond à la cuisson des couches.

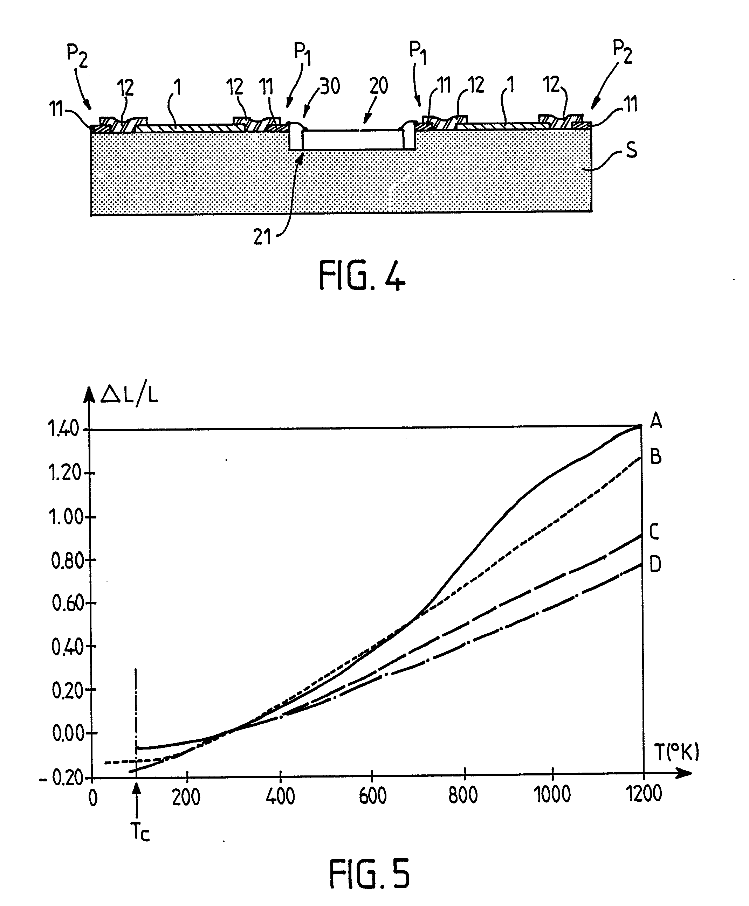

Dans ce domaine de température, si l'on choisit comme composé supraconducteur $YBa_2Cu_3Oy$, le substrat qui présente le coefficient de dilatation continuellement le plus proche est une céramique de magnésie MgO, comme le montrent les courbes de la figure 5 qui représentent l'écart linéaire relatif $\Delta L/L$ de Y-Ba-Cu-O (courbe A) de MgO (courbe B), $Al_2O_3$ (courbe C) et $ZrO_2$ (courbe D), en fonction de la température T en degrés K, où $T_c$ est le point où se produit l'effet supraconducteur c'est-à-dire où la résistivité zéro est obtenue.

La magnésie présente sur les autres composés pour substrat, un avantage supplémentaire. Elle montre une forte conductibilité thermique, qui permet d'obtenir facilement et rapidement le refroidissement du circuit supraconducteur pour arriver au fonctionnement.

Enfin la magnésie possède en tant que céramique des propriétés non négligeables qui sont une bonne résistance mécanique, et une faculté d'usinage facile. Ces propriétés permettent d'obtenir aisément des substrats de toutes sortes de formes et notamment :

- munis d'une cavité (100) pour recevoir ou faire circuler un fluide réfrigérant comme représenté sur la figure 2 ;

- munis d'une queue (110) pour être immergé dans un fluideréfrigérant comme représenté sur la figure 3 ;

- en forme de boîtier pour circuit intégré (20) comme représenté sur la figure 4. La figure 4 montre que le substrat S est ici muni d'un logement 21 pour recevoir une plaquette de circuit intégré 20. Des plots $P_1$ sont réalisés à la périphérie du logement, correspondant aux entrées/sorties du circuit intégré et sont reliés à ces dernières par des fils courts et fins, fixés par exemple par thermo-compression sur la couche 11 des plots $P_1$. D'autres plots $P_2$ sont réalisés à la périphérie du substrat S qui sert de support ou de boîtier au circuit intégré. Les plots $P_1$ sont reliés aux plots $P_2$ par des lignes 1 et des connexions 12.

Du fait que la magnésie présente un coefficient de dilatation très proche de celui de $YBa_2Cu_3Oy$ choisi comme composé supraconducteur sérigraphiable, il ne se produit pas de fentes dans la couche à la suite des traitements thermiques, et cet accord des coefficients de dilatation favorise aussi l'adhérence de la couche. Il ne sera donc pas nécessaire de monter à des températures de cuisson très élevées, pour obtenir cette adhérence.

Ceci est un point très important quand on sait que la fusion de $YBa_2Cu_3Oy$ est non congruente, c'est-à-dire que, au-dessus d'une température qui a été déterminée comme étant 920 à $930°$ C, ce matériau se décompose, ce qui a été observé dans l'état de la technique pour des températures citées comme étant de l'ordre de $1000°$ C.

La température de cuisson de la couche d'Y-Ba-Cu-0 pourra ne pas dépasser cette température déterminée de $920°$ C, du fait que l'accord des coefficients de dilatation entre Y-Ba-Cu-0 et MgO permet d'obtenir l'adhérence déjà à cette température.

En outre, selon la présente invention il est proposé de réaliser également les plots de contact P aux extrémités des lignes supraconductrices 1 par une couche sérigraphiée 11 qui sera formée à partir d'une encre dont la phase active est constituée d'un métal choisi parmi Au, Au-Pd, Au-Pt, Ag-Pd, Ag-Pt, couche qui sera de préférence déposée antérieurement au dépôt de la couche supraconductrice, mais sur un même niveau, comme il est montré en coupe sur la figure 1. Les lignes supraconductrices 1 seront reliées aux plots P correspondants par une couche 12 déposée ultérieurement à la couche supraconductrice disposée sur un second niveau, et formée d'une encre sérigraphiable à l'argent.

Un procédé de réalisation apte à obtenir le circuit selon l'invention comprend au moins les étapes de :

a) formation d'un substrat S en magnésie polycristalline (MgO) frittée de dimension et forme appropriées à recevoir le circuit, présentant par exemple des formes telles que représentées en coupe sur les figures 1, 2, 3 ou 4 ;

b) formation d'une encre conductrice sérigraphiable au moyen du mélange de départ d'une phase active formée d'une poudre métallique choisie parmi l'or (Au) ou l'argent-palladium (Ag-Pd) ou Or-Palladium (Au-Pd) ou l'Or-Platine (Au-Pt) ou l'argent-platine (Ag-Pt) mêlée à un verre formé de PbO, $B_2O_3$, $Al_2O_3$, $SiO_2$ dans les proportions molaires respectives d'environ 40 %, 20 %, 5 % et 35 %. Ce mélange dans lequel le métal entre dans les proportions de $\simeq$ 95 % en volume est réalisé au moyen d'un mélangeur à mortier et est incorporé à un véhicule rhéologique dans les proportions d'environ 50 % en volume. Ce véhicule rhéologiques peut être une solution d'éthyl-cellulose dans le terpinéol, par exemple 3 à 10 % d'éthyl-cellulose dans le terpinéol.

c) dépôt par sérigraphie sur le substrat de magnésie d'une couche 11 d'encre conductrice précédente selon un dessin approprié à constituer les plots P de contacts électriques pour le circuit de lignes supraconductrices 1.
La couche 11 ainsi sérigraphiée est cuite de préférence à 900°C avant la poursuite des étapes du procédé. Mais cette cuisson n'est pas obligatoire pour mettre en oeuvre la suite du procédé.

d) formation d'une poudre au moyen du mélange (pendant environ 1 heure) des poudres suivantes et dans les proportions ci-après :
$Y_2O_3$ 0,5 mole
$BaCO_3$ 2 moles
CuO 3 moles
ou bien au moyen du mélange de poudres suivantes dans les proportions :
$Y_2O_3$ 0,5 mole
$BaO_2$ 2 moles
CuO3 moles

e) Chauffage de la poudre résultant de ce mélange à 900°C durant un temps qui peut aller de 10 à 18 heures, de préférence 16 heures, conduisant à la formation d'une poudre de $YBa_2Cu_3O_{7-x}$, qui est obtenue par interdiffusion à l'état solide, à l'air, ou de préférence sous oxygène, dans un creuset en alumine $Al_2O_3$.

f) Broyage des grains de cette poudre durant 1 à 3 heures pour parfaire le mélange et obtenir des grains de diamètre 8 à 12 $\mu$m.

g) Mélange de cette poudre à un véhicule rhéologique qui peut être une solution d'éthyl-cellulose dans le terpinéol, par exemple 3 à 10 d'éthyl-cellulose dans le terpinéol, pour obtenir une encre sérigraphiable, dans les proportions en volume :
40 à 50 % de poudre de $YBa_2Cu_3O_{7-x}$
60 à 50 % de fluide rhéologique,
les proportions préférées étant :
45 % de poudre de $YBa_2Cu_3O_{7-x}$ 55 % de fluide rhéologique.

h) Sérigraphie selon un schéma approprié à former un circuit donné de lignes supraconductrices 1 au moyen de l'encre résultant de l'étape g) précédente et sur le substrat en magnésie ainsi formé, les plots de contact P selon l'étape b) n'étant pas recouverts, par la couche 1, mais des parties des lignes conductrices se trouvant à proximité de plots P ;

i) Séchage de la couche de $YBa_2Cu_3O$ sérigraphiée par chauffage à environ 120°C pendant environ 15 mn.

j) Cuisson de cette couche à la température précise de 920° $\pm$ 10°C, pendant 5 à 20 heures, de préférence pendant 16 heures, à l'air ou de préférence sous oxygène.

k) Refroidissement lent par exemple de 1°C/mn, jusqu'à la température ambiante, sous oxygène.

Dans la mesure où les lignes supraconductrices 1 ainsi réalisées sont destinées à relier des composants pour faire un circuit hybride, ou bien à former les connexions d'entrées-sorties d'une plaquette de circuit intégré disposé sur un boîtier, ou sur un substrat, boîtier ou substrat qui seront alors en magnésie, ces lignes supraconductrices 1 sont munies de plots de contact électrique, réalisés comme on l'a vu, de façon favorable, par la même technologie de sérigraphie. Mais ces plots de contacts doivent être prévus tels qu'ils ne détériorent pas les performances supraconductrices des lignes de connexion. C'est pourquoi, selon l'invention, on a prévu de réaliser la connexion entre la couche supraconductrice 1 et les plots P de couche 11 au moyen d'une couche 12, d'une encre sérigraphiable à l'argent, cette couche 12 étant réalisée sur un second niveau, comme il est montré sur la figure 1.

A cet effet, le procédé de réalisation se poursuit de la façon suivante :

l) Formation d'une encre sérigraphiable à l'argent (Ag) par le mélange de, en proportions volumiques :
40 à 50 % d'argent Ag pur en poudre
60 à 50 % d'un véhicule rhéologique tel qu'une solution d'éthyl-cellulose dans le terpinéol, par exemple 3 à 10 % d'éthyl-cellulose dans le terpinéol.

m) Sérigraphie de l'encre ainsi obtenue pour former une couche 12 recouvrant partiellement les plots 11 réalisés à l'étape b) et au moins une partie de la couche supraconductrice 1 d'Y-Ba-Cu-O placée à proximité des plots ;

n) Chauffage de l'ensemble du dispositif à environ 600° C pendant 10 à 18 heures de préférence 16 heures,

o) Refroidissement lent jusqu'à une température de palier de 410° C par exemple d'1° C par mn. Durant l'opération m) de réchauffement de l'ensemble du dispositif et l'opération de refroidissement jusqu'au palier de l'étape p) d'une part on obtient la cuisson de la couche 12 d'argent sérigraphiée à l'étape I), résultant en une bonne adhérence de cette dernière, et d'autre part, le matériau supraconducteur absorbe de l'oxygène, ce maximum d'absorption se situant vers 410° C. Si le matériau d'Y-Ba-Cu-O est porté en-dessous de 410° C, il n'absorbe pas assez d'oxygène pour arriver à la composition finale voulue telle que $0 < x < 0,5$ ;

p) Palier pendant une durée de 1 à 20 heures, de préférence 16 heures à la température de 410° C.

q) Refroidissement jusqu'à la température ambiante, par exemple à 1° C par mn, ou plus.

La température critique $T_c$ de transition supraconductrice obtenue est alors égale ou supérieure à 79° K.

**Revendications**

1. Dispositif électronique comprenant, réalisé sur un substrat en céramique, un circuit formé d'au moins une couche sérigraphiée pour réaliser des conducteurs, et une couche sérigraphiée pour réaliser des plots de contact électrique avec les conducteurs, caractérisé en ce que le substrat est en magnésie (MgO) frittée polycristalline, et en ce que la couche réalisant les conducteurs est en $YBa_2Cu_3O_{7-x}$ supraconducteur, où $0 < x < 0,5$.

2. Dispositif selon la revendication 1, caractérisé en ce que les plots de contact sont formés d'une couche sérigraphiée conductrice dont la phase active est constituée d'un métal choisi parmi l'or, l'argent-palladium, l'or-palladium, l'or-platine ou l'argent-platine et en ce que ces plots sont reliés aux conducteurs supraconducteurs par une couche d'argent sérigraphiée en second niveau.

3. Dispositif selon l'une des revendications 1 ou 2, caractérisé en ce que le circuit constitue un circuit du type dit hybride.

4. Dispositif selon la revendication 3, caractérisé en ce que, sur le substrat en céramique, est disposée en outre une plaquette de circuit intégré, et en ce que des conducteurs du circuit hybride constituent des connexions d'entrées-sorties de la plaquette de circuit intégré.

5. Dispositif selon la revendication 4, caractérisé en ce que le substrat en céramique constitue le boîtier-support de la plaquette de circuit intégré.

6. Dispositif selon l'une des revendications précédentes, caractérisé en ce que le corps du substrat en céramique présente un évidement pour permettre l'introduction d'un fluide de refroidissement.

7. Dispositif selon l'une des revendications 1 à 5, caractérisé en ce que le corps du substrat en céramique présente un évidement pour permettre la circulation d'un fluide de refroidissement.

8. Dispositif selon l'une des revendications 1 à 5, caractérisé en ce que le corps du substrat en céramique présente une queue pour être immergé dans un fluide de refroidissement.

9. Procédé de réalisation d'un dispositif selon l'une des revendications 1 à 8, comprenant au moins les étapes de :

a) formation d'un substrat en magnésie MgO polycristalline frittée,

b) formation d'une encre conductrice sérigraphiable au moyen du mélange de départ de
- un métal en poudre choisi parmi Au, Ag-Pd, Au-Pd, Au-Pt, Ag-Pt ;
- d'un verre formé de PbO, $B_2O_3$, $Al_2O_3$, $SiO_2$ en proportions molaires respectives d'environ 40 %, 20 %, 5 %, 35 %, ce mélange de départ dans lequel le métal est en proportion d'environ 95 % en volume étant incorporé dans un véhicule rhéologique, tel qu'une solution d'éthyl-cellulose dans le terpinéol, par exemple 3 à 10 % d'éthyl-cellulose dans le terpinéol, dans les proportions environ moitié, en volume ;

c) dépôt par sérigraphie sur le substrat de magnésie, d'une couche de l'encre conductrice précédente selon un dessin approprié à constituer les plots de contact électrique du circuit prévu et cuisson éventuelle de cette couche conductrice à 900° C,

d) formation d'une poudre du mélange choisi parmi

$Y_2O_3$ 0,5 mole
$BaCO_3$ 2 moles
CuO 3 moles
ou bien
$Y_2O_3$ 0,5 mole
$BaO_2$ 2 moles
CuO 3 moles,

e) chauffage de cette poudre à 900° C durant un temps de 10 à 18 heures résultant en la formation d'une poudre de $YBa_2Cu_3O_{7-x}$ par diffusion à l'état solide, sous flux d'oxygène,

f) Broyage des grains de cette poudre durant 1 à 3 heures résultant en une poudre de grains de diamètre 8 à 12 $\mu m$,

g) mélange de cette poudre à un véhicule organique pour obtenir une encre sérigraphiable dans les proportions volumiques de :
40 à 50 % de poudre de $YBa_2Cu_3O_{7-x}$
60 à 50 % de fluide rhéologique, tel qu'une solution d'éthyl-cellulose dans le terpinéol, par exemple 3 à 10 % d'éthyl-cellulose dans le terpinéol,

h) sérigraphie de l'encre obtenue selon l'étape g) selon un dessin approprié à former un circuit donné de conducteurs, ces conducteurs présentant des parties à proximité des plots réalisés à l'étape c),

i) séchage de la couche pendant environ 15 mn à environ 120° C,

j) cuisson de la couche durant 5 à 20 heures à exactement 920° C±10° C sous oxygène,

k) refroidissement lent de par exemple 1° C/mn jusqu'à la température ambiante, sous oxygène.

10. Procédé de réalisation selon la revendication 9, caractérisé en ce qu'il comprend en outre les étapes de

l) formation d'une encre conductrice sérigraphiable à l'argent par mélange de, en proportions volumiques :
40 à 50 % d'Ag en poudre
60 à 50 % d'un fluide rhéologique, tel qu'une solution d'éthyl-cellulose dans le terpinéol, par exemple 3 à 10 % d'éthyl-cellulose dans le terpinéol ;

m) sérigraphie d'une couche de l'encre conductrice précédente pour former des connexions entre les plots de contacts électriques réalisés lors de l'étape c), et les conducteurs supraconducteurs, de telle manière que au moins une partie de couche de matériau supraconducteur et au moins une partie du plot de contact situé à proximité se trouvent recouverts par cette seconde couche conductrice ;

n) chauffage de l'ensemble du dispositif à environ 600° C durant 10 à 18 heures,

o) refroidissement lent jusqu'à une température de palier de 410° C par exemple d'1° C par mn, de telle façon que dans la composition des couches supraconductrices $0 < x < 0,5$.

p) palier à 410° C pendant 1 à 20 heures,

q) refroidissement à environ 1°/mn jusqu'à la température ambiante.

FIG. 1

FIG. 2

FIG. 3

FIG. 4

FIG. 5

2-II-PHF 88-540

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | THE 1988 PROCEEDINGS OF THE 38TH ELECTRONIC COMPONENTS CONFERENCE, Los Angels, California, 9-11 mai 1988, pages 136-143, IEEE; A. OCHI et al.: "Synthesis and characterization of high-Tc superconducting ceramics" * Résumé; page 136, colonne 3, lignes 25-60; figure 14; page 142, colonne 1, lignes 5-13; tableau 2 * --- | 1,9 | H 01 L  39/12 H 01 L  39/14 H 01 L  27/18 |
| D,A | APPLIED PHYSICS LETTERS, vol. 51, no. 16, 19 octobre 1987, pages 1277-1279, American Institute of Physics, New York, US; R.C. BUDHANI et al.: "Synthesis of superconducting films of the Y-Ba-Cu-O system by a screen printing method" * Résumé; page 1277, colonne 1, lignes 22-36; page 1278, colonne 1, ligne 11-colonne 2, ligne 6 * --- | 1,9 | |
| D,A | JAPANESE JOURNAL OF APPLIED PHYSICS, vol. 26, no. 5, mai 1987, pages L763-L765, Tokyo, JP; H. KOINUMA et al.: "Some problems in the preparation of superconducting oxide films on ceramic substrates" * Page L763, paragraphe 3 * --- | 1,9 | DOMAINES TECHNIQUES RECHERCHES (Int. Cl.4) H 01 L |
| A | JAPANESE JOURNAL OF APPLIED PHYSICS, vol. 26, no. 5, partie 2, mai 1987, pages L736-L737, Tokyo, JP; T. KAWAI et al.: "Preparation of high-Tc Y-Ba-Cu-O superconductor" * Résumé; page L736, colonne 1, paragraphe 3 * ---          -/- | 2 | |

Le présent rapport a été établi pour toutes les revendications

| Lieu de la recherche | Date d'achèvement de la recherche | Examinateur |
|---|---|---|
| LA HAYE | 05-09-1989 | MIMOUN B.J. |

EPO FORM 1503 03.82 (P0402)

Office européen
des brevets

# RAPPORT DE RECHERCHE EUROPEENNE

Numero de la demande

EP  89 20 1261

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | SPIE VOL. 948 HIGH-TC SUPERCONDUCTIVIY: THIN FILMS AND DEVICES (1988), pages 3-9, Bellingham, Washington, US; B.A. BIEGEL et al.: "Ultra high speed electronics based on proposed high Tc superconductor switching devices" * Résumé; page 4, colonne 1, ligne 20 - colonne 2, ligne 6 * ----- | 2-6 | |
| | | | DOMAINES TECHNIQUES RECHERCHES (Int. Cl.4) |

Le présent rapport a été établi pour toutes les revendications

| Lieu de la recherche | Date d'achèvement de la recherche | Examinateur |
|---|---|---|
| LA HAYE | 05-09-1989 | MIMOUN B.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P0402)